# EUROPÄISCHE PATENTSCHRIFT

(11) **EP 0 486 886 B1**
(45) Veröffentlichungstag und Bekanntmachung des Hinweises auf die Patenterteilung: **14.02.1996**
(21) Anmeldenummer: 91118966.0
(22) Anmeldetag: 07.11.1991
(51) Int. Cl.: E06B 5/18, B32B 15/08, H05K 9/00

(54) **Anordnung zum Abdichten einer Trenn- oder Verbindungsfuge zwischen zwei Bauteilen im wesentlichen aus Kunststoff**
Sealing arrangement for joints between two elements essentially consisting of plastic
Dispositif d'étanchéité de joints entre deux éléments consistant essentiellement en matière plastique

(30) Priorität: 22.11.1990 DE 4037119
(43) Veröffentlichungstag der Anmeldung: 27.05.1992
(73) Patentinhaber: Eurocopter Deutschland Gesellschaft mit beschränkter Haftung, D-81611 München (DE)
(72) Erfinder: von Panajott, Andreas, W-8202 Bad Aibling (DE)
(74) Vertreter: Frick, Gerhard, Dipl.-Ing.

(56) Entgegenhaltungen:
- EP-A- 0 274 108
- EP-A- 0 309 362
- EP-A- 0 318 839
- EP-A- 0 371 905
- EP-A- 0 392 821
- EP-A- 0 403 112
- DE-U- 9 010 836

## Beschreibung

Die Erfindung betrifft eine Anordnung zum Abdichten einer Trenn- oder Verbindungsfuge gemäß dem Oberbegriff des Patentanspruchs 1.

Bei Dichtungsmaterial zum fluiddichten Abdichten und zugleich elektromagnetischen Abschirmen oder elektrischen Uberbrücken von Trennfugen ist üblicherweise der Kern ein Metalldrahtgeflecht o. dgl., beispielsweise entsprechend der bei einem durch die DE-OS 36 08 938 bekannten flächigen Verbundwerkstoff zur elektrostatischen Schirmung bestimmten Metalleinlage,durch welche vorteilhafterweise das Gewicht des Verbundwerkstoffes im Vergleich zu Werkstoffen ausschließlich aus Kunstharz nur gering erhöht und dennoch eine gute elektrische Leitfähigkeit erzielt wird. In Dichtungsmaterial hat jedoch ein solches Metalldrahtgeflecht eine unerwünschte Versteifung und damit zur Folge, daß die Dichtung unebenen Fugenflächen nur schwer anpaßbar ist. Aus diesem Grunde werden zunehmend flexible Dichtungsprofile aus Kunststoff mit einem Zusatz von leitfähigem Material, wie Kohlenstoff, bevorzugt, welche allerdings einen Flächenkontakt mit der elektromagnetischen Abschirmung in der Oberfläche des jeweiligen gefügten Bauteils erfordern. Dazu muß das betreffende Metalldrahtgeflecht an der Bauteiloberfläche freigelegt werden. Erfahrungsgemäß läßt sich zwar Oberflächenkunststoff über dem Metalldrahtgeflecht einfach durch Sandstrahlen entfernen, jedoch kann hierbei eine Beschädigung des Metalldrahtgeflechtes nicht ohne weiteres ausgeschlossen werden .

Der Erfindung liegt daher die Aufgabe zugrunde, solche Beschädigungen der Abschirmung im einzelnen Bauteil (durch Entfernen von Oberflächenkunststoff) bei einer Anordnung der eingangs genannten Art auszuschließen ohne Minderung des elektrischen Kontaktes zwischen der Berührungsdichtung und der einzelnen Abschirmung sowie zwischen den beiden Bauteilen bzw. deren Abschirmungen.

Diese Aufgabe ist für eine gattungsgemäße Abdichtungsanordnung mit den kennzeichnenden Merkmalen des Patentanspruchs 1 gelöst. Bei einer derartigen Anordnung wird nicht nur die einzelne Abschirmung in der Fuge verschleißsicher und gutleitend abgedeckt, sondern ist zugleich die abdeckende Metallfolie und folglich auch die zugeordnete Abschirmung gegen Feuchtigkeit, d.h. Korrosion, geschützt. Dies läßt sich nach den in den Unteransprüchen gekennzeichneten Ausgestaltungen der Erfindung durch einfache Mittel und Maßnahmen sicherstellen.

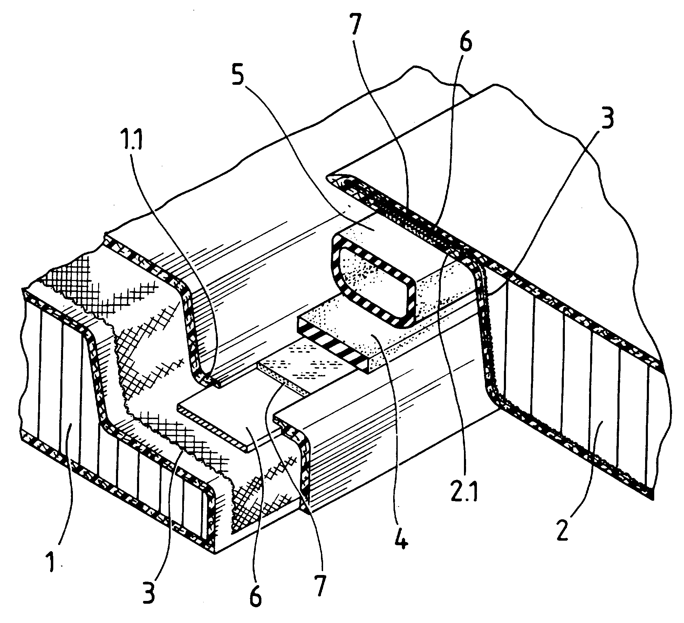

Nachfolgend wird die Erfindung anhand eines Ausführungsbeispieles weiter erläutert. Dabei zeigt die Zeichnung in einer Perspektive und teilweise aufgebrochen einen Ausschnitt einer Trennfuge zwischen einem stationären Kunststoffbauteil, z.B. einer Behälterwandung, und einem demgegenüber bewegbaren Kunststoffbauteil 2, z.B. einem Türflügel. Beide Kunststoffbauteile 1, 2 weisen eine Sandwichstruktur auf, jeweils mit einer elektromagnetischen Abschirmung 3 in Form eines Metalldrahtgeflechtes in der Kunststoffoberfläche 1.1 bzw. 2.1. Die beiden Abschirmungen 3 der Kunststoffbauteile 1, 2 müssen in der dargestellten geschlossenen Position des bewegbaren Kunststoffbauteils 1 elektrisch leitend verbunden sein, wobei die Trennfuge fluiddicht sein soll. Zu diesem Zweck ist in der Trennfuge eine fluiddichte, flexible, elektrisch leitende Berührungsdichtung aus zwei längs der Trennfuge miteinander in Flächenkontakt stehenden Dichtungsprofilen 4, 5 angeordnet, welche z.B. aus einem kohlenstoffhaltigen Kunststoff bestehen, wie Silikon oder Polytetrafluorethylen mit einem Kohlenstoffpulveranteil. Längs der Fugenflächen ist je Kunststoffbauteil 1,2 ein Dichtungsprofil 4 bzw. 5 der Abschirmung 3 unter Zwischenfügung je einer Metallfolie 6 zugeordnet. Aus Gründen eines Korrosionsschutzes bestehen die Abschirmung 3 und zugehörige Metallfolie 6 je Kunststoffbauteil 1, 2 vorzugsweise aus gleichem Werkstoff, z.B. Kupfer. Die Abdeckung der einzelnen Abschirmung 3 durch ihre Metallfolie 6 ist auf den Fugenbereich des jeweiligen Kunststoffbauteils 1, 2 beschränkt. Hierbei ist die Metallfolie 6 nur nach Maßgabe einer für die Berührungsdichtung bzw. das zugeordnete Dichtungsprofil 4 oder 5 nötigen Kontaktfläche von der abdeckenden Kunststoffoberfläche 1.1 bzw. 2.1 befreit, welche im übrigen den jeweiligen Verbund der Metallfolie 6 mit der zugehörigen Abschirmung 3 sichert. Die Breite des Dichtungsprofils 4, 5 je Kunststoffbauteil 1 bzw. 2 ist größer als die Kontaktfläche der zugehörigen Metallfolie 6, so daß diese und damit die zugeordnete Abschirmung 3 zugleich gegen die Trennfuge abgedichtet ist. Dabei wird der Verbund der Dichtungsprofile 4, 5 mit der zugehörigen Metallfolie 6 durch eine elektrisch leitende Klebverbindung 7 (mit sog. Leitkleber) gesichert. Soweit ein einziges Dichtungsprofil (z.B. 5) für die Abdichtung der Trennfuge ausreichend ist, kann auch das andere Dichtungsprofil (z.B. 4) durch eine die zugehörige Kontaktfläche der betreffenden Metallfolie 6 fluiddicht bedeckende elektrisch leitfähige Schicht z.B. aus einem sog. Leitlack o. dgl. ersetzt sein.

## Patentansprüche

1. Anordnung zum Abdichten einer Trenn- oder Verbindungsfuge zwischen zwei Bauteilen im wesentlichen aus Kunststoff, in deren gefügten Oberflächen jeweils eine elektromagnetische Abschirmung in Form eines Metalldrahtgeflechtes, -gitters o. dgl. Gefüges eingebettet ist, welche Abschirmung für einen elektrischen Flächenkontakt mit einer in der Fuge sich erstreckenden fluiddichten, flexiblen, elektrisch leitenden Berührungsdichtung von Oberflächenkunststoff längs der Fugenflächen befreit ist, **dadurch gekennzeichnet**, daß die Abschirmung (3) im von Oberflächenkunststoff freien Bereich je Bauteil (1, 2) mit einer Metallfolie (6) bedeckt ist und diese Metallfolie (6) nach Maßgabe einer für die Berührungsdichtung nötigen Kontaktfläche von einer den Metallfolienverbund mit der zugeordneten Abschirmung (3) sichernden Kunststoffoberfläche (1.1 bzw. 2.1) befreit und an dieser Kontaktfläche durch die Berührungsdichtung (4, 5) abgedeckt ist.

2. Trenn- oder Verbindungsfuge nach Anspruch 1, **dadurch gekennzeichnet**, daß die Berührungsdichtung aus zwei längs der Fuge miteinander in Flächenkontakt stehenden Dichtungsprofilen (4, 5) gebildet wird, von denen jeweils eines einem Bauteil (1 bzw. 2) als Abdeckung der Kontaktfläche der Metallfolie (6) zugeordnet ist.

3. Trenn- oder Verbindungsfuge nach Anspruch 2, **dadurch gekennzeichnet**, daß das Dichtungsprofil (4, 5) und die zugehörige Metallfolie (6) in elektrisch leitender Klebverbindung (7) stehen.

4. Trenn- oder Verbindungsfuge nach Anspruch 1, **dadurch gekennzeichnet**, daß die Abschirmung (3) und die zugehörige Metallfolie (6) aus gleichem Werkstoff bestehen.

5. Trenn- oder Verbindungsfuge nach Anspruch 2, **dadurch gekennzeichnet**, daß die Dichtungsprofile (4, 5) aus einem kohlenstoffhaltigen Kunststoff bestehen.

6. Trenn- oder Verbindungsfuge nach Anspruch 2, **dadurch gekennzeichnet**, daß die Breite des Dichtungsprofils (4, 5) größer ist als die Kontaktfläche der zugehörigen Metallfolie (6) .

## Claims

1. An arrangement for sealing a separating or jointing gap between two assembly components essentially of plastic material, with electro-magnetic screening in the form of a metal wire mesh or metal wire grid or the like embedded in their jointed surfaces, and that this screening for an electrical surface contact with a fluidically sealing, flexible and electrically conducting contact seal is freed of surface plastic material along the jointing surfaces, **characterized in that** the screening (3) in the area of each assembly component (1, 2) which is free of surface plastic material is covered with a metal foil (6), and this metal foil (6) is, to suit a contact surface as required for the contact seal, freed of a plastic material surface (1.1 or 2.1) which secures the metal-foil lamination with the associated screening (3) and covered at this contact surface by the contact seal (4. 5).

2. A separating or jointing gap according to claim 1, **characterized in that** the contact seal is composed of two sealing profiles (4, 5), which are in surface contact with each other along the gap and of which one is associated with an assembly component (1 or 2) as a cover of the contact surface of the metal foil (6).

3. A separating or jointing gap according to claim 2, **characterized in that** the sealing profile (4, 5) and the associated metal foil (6) are in an electrically conductive glued joint (7).

4. A separating or jointing gap according to claim 1, **characterized in that** the screening (3) and the associated metal foil (6) are of the same material.

5. A separating or jointing gap according to claim 2, **characterized in that** the sealing profiles (4, 5) are made of a plastic material containing carbon.

6. A separating or jointing gap according to claim 2, **characterized in that** the width of the sealing profile (4, 5) is greater than the contact surface of the associated metal foil (6).

## Revendications

1. Agencement pour rendre étanche un joint de séparation ou un joint d'assemblage entre deux éléments de construction essentiellement en matériau synthétique, dans la surface d'assemblage desquels est noyé un blindage électromagnétique se présentant sous la forme d'un tissu de fils métalliques, d'une grille de fils métalliques ou d'une structure similaire, lequel blindage, aux fins de réaliser un contact électrique sur une grandc surface avec une garniture d'étanchéité par contact électroconductrice, souple et étanche aux fluides disposée dans l'interstice, est débarrassé du matériau synthétique superficiel le long des surfaces d'assemblage, caractérisé par le fait que le blindage (3), dans la zone débarrassée de la couche superficielle de matériau synthétique de chaque élément (1, 2), est recouvert d'une feuille (6) métallique et par le fait que, en fonction de la surface de contact nécessaire pour la garniture d'étanchéité, la feuille (6) métallique est débarrassée d'une couche (1.1 et 2.1) de matériau synthétique qui assure la liaison entre ladite feuille métallique et le blindage (3) associé et est recouverte au niveau de ladite surface de contact par la garniture d'étanchéité (4, 5) par contact.

2. Joint de séparation ou joint d'assemblage selon la revendication 1, caractérisé par le fait que la garniture d'étanchéité par contact est formée de deux profilés (4, 5) d'étanchéité qui sont disposés le long de l'interstice, sont en contact de surface l'un avec l'autre et sont associés chacun à un élément de construction (1 et 2) en tant que moyen de recouvrement de la surface de contact de la feuille (6) métallique.

3. Joint de séparation ou d'assemblage selon la revendication 2, caractérisé par le fait que le profilé d'étanchéité (4, 5) et la feuille (6) métallique associée sont liés par adhésif (7) de manière électro-conductrice.

4. Joint de séparation ou d'assemblage selon la revendication 1, caractérisé par le fait que le blindage (3) et la feuille (6) métallique associée sont réalisés en un même matériau.

5. Joint de séparation ou d'assemblage selon la revendication 2, caractérisé par le fait que les profilés d'étanchéité (4, 5) sont en un matériau synthétique à base de carbone.

6. Joint de séparation ou d'assemblage selon la revendication 2, caractérisé par le fait que la largeur des profilés d'étanchéité (4, 5) est supérieure à la surface de contact de la feuille (6) métallique associée.
